# EUROPÄISCHE PATENTSCHRIFT

(11) **EP 1 733 073 B1**
(45) Veröffentlichungstag und Bekanntmachung des Hinweises auf die Patenterteilung: **08.09.2021**
(21) Anmeldenummer: 05750695.8
(22) Anmeldetag: 09.03.2005
(51) Int. Cl.: C23C 16/455, C23C 16/448

(54) **VERFAHREN ZUM ABSCHEIDEN VON INSBESONDERE METALLOXIDEN MITTELS NICHT KONTINUIERLICHER PRECURSORINJEKTION**
METHOD FOR THE DEPOSITION IN PARTICULAR OF METAL OXIDES BY NON-CONTINUOUS PRECURSOR INJECTION
PROCEDE DE DEPOT NOTAMMENT D'OXYDES METALLIQUES PAR INJECTION NON CONTINUE DE PRECURSEURS

(30) Priorität: 27.03.2004 DE 102004015174
(43) Veröffentlichungstag der Anmeldung: 20.12.2006
(73) Patentinhaber: Eugenus, Inc., San Jose, CA 95134 (US)
(72) Erfinder: BAUMANN, Peter, 52072 Aachen (DE); SCHUMACHER, Marcus, 50171 Kerpen (DE); LINDNER, Johannes, 52159 Roetgen (DE)
(74) Vertreter: Grundmann, Dirk
(86) Internationale Anmeldenummer: PCT/EP2005/051050
(87) Internationale Veröffentlichungsnummer: WO 2005/093127

(56) Entgegenhaltungen:
- WO-A-02/27063
- US-A1- 2003 224 578
- None

## Beschreibung

Die Erfindung betrifft ein Verfahren zum Abscheiden mindestens einer Schicht auf mindestens einem Substrat in einer Prozesskammer, wobei die Schicht aus mindestens zwei Komponenten besteht, wobei zumindest eine erste metallische Komponente unter Verwendung einer nicht kontinuierlichen Injektion eines flüssigen oder eines in einer Flüssigkeit gelösten ersten Ausgangsstoffes in ein insbesondere temperiertes Trägergas verdampft wird und eine zweite Komponente als chemisch reaktiver Ausgangsstoff zugeführt wird, dadurch gekennzeichnet, dass die Ausgangsstoffe abwechselnd in die Prozesskammer eingebracht werden.

Zum Abscheiden von metalloxidischen Schichten wie Hafniumoxid, oder Aluminiumoxid, oder auch Praseodymoxid werden in der Literatur Verfahren wie, Molecular Beam Epitaxy (MBE), Metal Organic Chemical Vapor Deposition (MOCVD), und Atomic Layer Deposition (ALD) aufgeführt.

MBE erzielt keine konformale Kantenbedeckung bei der Abscheidung von dünnen Schichten während MOCVD- und ALD-Verfahren gute Kantenbedeckung bei der Abscheidung auf strukturierten Substraten gewährleisten. Konventionelle MOCVD Verfahren, die auf der Verdampfung flüssiger oder fester Precursoren beruhen, verwenden üblicherweise beheizte Precursor Behälter (Bubbler) zur Überführung der Ausgangssubstanzen mittels eines Trägergases in die Gasphase. Die meisten Precursoren für oxidische Materialien (bzw. entsprechende verdünnte Lösungen) sind meist schwer flüchtig und chemisch wie thermisch instabil und verändern bzw. zersetzen sich unter diesen thermischen Bedingungen, was die Abscheidung nicht reproduzierbar macht. Insbesondere lässt sich eine vollständige Sättigung der Gasphase und damit hohe Wachstumsraten über solche Anordnungen nur schwer erzielen. Daher wurden für MOCVD verschiedene Flüssig-Precursor-Zuführungs-Systeme entwickelt, die auf abrupter Verdampfung kleiner Precursormengen durch direkten Kontakt mit beheizten Oberflächen beruhen. Dies zieht Nachteile mit sich wie zeitlich verändertes Verdampfungsverhalten durch Ablagerungen auf den beheizten Oberflächen und Partikelbildung. Durch periodische Injektion von Flüssigprecursoren in ein geheiztes Volumen mit anschließender kontaktfreien Verdampfung wird berichtet, dass diese Nachteile vermieden werden können, wenn gleich nicht für mehrere Quellen beschrieben (US 5945162). Bei konventioneller MOCVD ergeben sich auf Grund der schlechten atomaren Präzision Unzulänglichkeiten hinsichtlich der Schichtendickenkontrolle z.B. bei der Abscheidung von Nanolaminaten. Oft wird zusätzlich bei der konventionellen MOCVD im Gegensatz zu ALD- Verfahren über unzureichende Kantenbedeckung bei der Abscheidung auf hoch strukturierten Substraten berichtet.

ALD-Verfahren greifen allerdings auf eine sehr kleine Anzahl verfügbarer Precursoren zurück, diese basieren oft auf Chlor-Verbindungen. Durch alternierendes Einbringen von z.B. gasförmigen H₂O als Oxidant in die Prozesskammer entsteht dabei HCl als Produkt welches sich jedoch recht schwierig sicherheitstechnisch als Abgasbestandteil behandeln lässt.

Im Speziellen weisen ALD-Verfahren die auf Feststoffquellen (Bubbler) zurückgreifen meist Probleme mit nicht hinreichender erreichbarer Gasphasensättigung auf, da nicht immer genügend Ausgangssubstanz gasförmig über Bubbleranordnungen aufgrund eingeschränkter Sublimationsprozesse generiert werden. Bei Systemen mit mehr als einem zu beschickenden Substrat und größeren Reaktionskammervolumina ist dieses Problem besonders ausgeprägt. Dieses Phänomen bedingt eine für Produktionszwecke unzureichende Wachstumsrate und ggf. inhomogene Beschichtung der Substrate.

ALD beruht prinzipiell auf alternierenden, selbst limitierenden chemischen Reaktionen zur sukzessiven Abscheidung von Monolagen. Dies wird durch komplizierte Schaltung von Ventilen durchgeführt. Zwischen der Zuführung der einzelnen Reagenzien werden Pump und Spülzyklen eingeführt. Dies führt zu geringen Durchsätzen und ist besonders bei Einzelwafer ALD Systemen ein Nachteil.

Selbst die Herstellung von mehrkomponentigen Oxiden ist über ALD-Verfahren erschwert, wenn nicht sogar ganz unmöglich, da die Ausgangssubstanzen nicht wie bei Standard MOCVD-Verfahren bereits gemischt in der Gasphase vorliegen. Im Besonderen können daher durch ALD-Verfahren prinzipbedingt keine Schichten hergestellt werden, die ein gradienten-ähnliches Ändern von Mischungen mehrerer Metalloxiden unterschiedlicher Materialarten insitu während des Wachstumsprozesses erlauben. ALD weist weiterhin auch ein nichtlineares Wachstum in Abhängigkeit der Schichtdicke auf was speziell die Kontrollierbarkeit der Prozesse bei sehr kleinen Schichtdicken extrem erschwert.

Um die Weiterentwicklung elektronischer Bauteile z.B. für CMOS, DRAM Anwendungen zu gewährleisten wird u.a. nach hoch-k-Materialien als Alternativen zu SiO₂ als Dielektrikum gesucht. Als solche Kandidaten sind Aluminumoxid, Hafniumoxid oder auch Praseodymoxid aber im speziellen auch mehrkomponentige Oxide von ganz besonders hohem Interesse, da diese herausragende Eigenschaften hinsichtlich der Dielektrizitätszahl und der Leckströme aufweisen. Neue Erkenntnisse demonstrieren sogar verbesserte Materialeigenschaften über Laminierung bzw. Mischung dieser Metalloxide untereinander bzw. zur Verbesserung der thermischen Stabilität auch durch Beigabe von Silizium.

Im allgemeinen, scheinen reine Materialien wie reines HfO₂, Al₂O₃ bzw. auch Pr₂O₃ den Anforderungen hinsichtlich der Dielektrizitätszahl, des Leckstromes bzw. der thermischen Stabilität gleichzeitig nicht gerecht zu werden. Eine Mischung solcher oder ähnlicher Metall Oxide bzw. eine Dotierung scheint hierbei die Lösung zu sein. Standard ALD oder MBE-Verfahren sind nach jetzigem Stand der Technik aufgrund sehr geringer Wachstumsraten keine produktionswürdigen Lösungen für die beschriebene Schichtabscheidung mehrkomponentiger Materialien. Es wird daher ein Verfahren benötigt, das in industriellem Maßstab die kostengünstige, effiziente Abscheidung mit hohem Durchsatz hochreiner, mehrkomponentiger Metalloxide auf der Basis z.B. von Hafniumoxid, oder Aluminiumoxid, Schichten bei guter Reproduzierbarkeit, hoher Gleichförmigkeit und guter Kantenbedeckung auch auf hoch strukturierten Substraten gewährleistet.

Dabei soll ein Verfahren entwickelt werden, welches prinzipiell die Vorteile der klassischen MOCVD und der ALD Verfahren kombiniert, wobei die jeweiligen Nachteile umgangen werden. Atomare Schichtendickenkontrollierbarkeit, hohe Wachstumsgeschwindigkeit durch frei einstellbare, ausreichende Gasphasensättigung und der Möglichkeit normaler Abscheidung auf hoch strukturierten Topographien sollen gleichzeitig unter Vermeidung von unzureichender Gasphasensättigung, komplizierter Ventilverschaltungen für Wachstums- bzw. Spülzyklen, eingeschränkter Möglichkeiten bei der Abscheidung mehrkomponentiger Materialsysteme bei gleichzeitig geringer Auswahl von Quellenmaterialien vermieden werden.

Die DE 103 42 890 beschreibt eine Vorrichtung und ein Verfahren, bei dem zur Variation des Massenflusses der Precursor die Pulsweite bzw. die Pausen zwischen den Pulsen variiert werden.

Die DE 101 14 956 bzw. DE 100 57 491 A1 beschreibt die Verwendung verschiedener Ausgangsstoffe zum Abscheiden von Schichten nach dem eingangs genannten Verfahren.

Die US 2003/0224578 A1 beschreibt ein ALD-Verfahren, bei dem abwechselnd ein metallhaltiger Ausgangsstoff und ein reduzierendes Gas in einen konstanten Trägergasstrom eingebracht werden. Der konstante Trägergasstrom bringt die Ausgangsstoffe in die Prozesskammer einer Beschichtungsvorrichtung.

Die WO 02/27063 beschreibt ebenfalls ein ALD-Verfahren. Es sind zwei Reservoire vorgesehen, die jeweils einen flüssigen Ausgangsstoff bevorraten, der aus den Reservoiren in jeweils eine Kammer eintreten kann. Diese Kammer befindet sich in einem beheiztren Ofen. Mittels eines Trägergasstroms wird das in die Kammer eingebrachte Gas in die Depositionskammer gebracht. Der Zustrom der Ausgangsstoffe in die Depositionskammer erfolgt alternierend.

Der Erfindung liegt die Aufgabe zugrunde, ein technisch verbessertes ALD-Verfahren anzugeben.

Gelöst wird die Aufgabe durch die in den Ansprüchen angegebene Erfindung.

Der Anspruch 1 sieht zunächst und im Wesentlichen vor, dass die Ausgangsstoffe abwechselnd in die Prozesskammer eingebracht werden. Die Erfindung betrifft somit ein Verfahren, bei dem unter Verwendung von nicht kontinuierlicher Injektion eine flüssige oder eine in einer Flüssigkeit gelöste feste Ausgangssubstanz in ein geheiztes Volumen eingebracht wird. Dies kann durch Vernebeln mit einer geeigneten, ventilgesteuerten Düse erfolgen. Beim Einbringen der Flüssigkeit in das geheizte Volumen eines Trägergases wird dem Trägergas die Verdampfungsenergie entzogen. Der Massenfluss ist pro Puls dabei so eingestellt, dass das Trägergas in der Verdampfungskammer gesättigt wird. Dabei werden bevorzugt abwechselnd mindestens eine verdampfte Metall-Ausgangssubstanz und mindestens ein reaktives Gas verwendet. Zwischen den beiden Gaspulsen kann die Prozesskammer oder auch die Verdampfungskammer mit einem Trägergas gespült werden. Es ist aber auch vorgesehen, dass die Prozesskammer oder auch die Verdampfungskammer zwischen den beiden Gaspulsen abgepumpt wird. Wenn die beiden Ausgangsstoffe in einer gemeinsamen Verdampfungskammer verdampft werden, erweist es sich als vorteilhaft, diese auch zwischen den Pulsen zu spülen bzw. abzupumpen. Darüber hinaus kann vorgesehen sein, dass die Verdampfung der einzelnen Ausgangsstoffe in separaten Verdampfungskammern vollzogen wird. Hier ist es nicht notwendig, die Verdampfungskammer zwischen den Pulsen zu spülen oder abzupumpen, jedoch sollte hier auch die Prozesskammer zwischen den Pulsen gespült oder abgepumpt werden. Auch hier kann zwischen dem Umschalten von einer Ausgangssubstanz auf die andere pausiert werden. Während der Pause kann ein inertes Trägeras zugegeben werden. Es ist aber auch hier vorgesehen, dass innerhalb der Pausen die Vorrichtung, insbesondere die Prozesskammer abgepumpt wird. Das Spülen der Prozesskammer bzw. das Abpumpen der Prozesskammer erfolgt bei geheiztem Substrathalter. Auf dem Substrathalter liegen ein oder mehrere Substrate, die bei der Durchführung des Verfahrens beschichtet werden. Der Massenfluss kann dabei so eingestellt werden, dass pulsweise Monolage auf Monolage auf dem Substrat abgeschieden wird. In den Pausen zwischen den einzelnen Wachstumsschritten, während derer jeweils eine Monolage abgeschieden wird, haben die auf der Oberfläche angelagerten Moleküle Zeit, sich zu arrangieren. Durch die direkte Injektion von flüssigen bzw. gelösten Ausgangssubstanzen in ein oder mehrere geheizte Volumina wird eine vollständige Sättigung der Gasphase erzielt, wobei gleichzeitig auf komplizierte Ventilschaltungen zur Realisierung der Wachstums- bzw. Spülzyklen verzichtet werden kann. Mit dem beanspruchten Verfahren bzw. mit der zugehörigen Vorrichtung ist somit nicht nur das kontaktfreie Verdampfen von Metall oder Metalloxid-Quellenmaterialien möglich. Es wird auch eine hohe Gasphasensättigung in der Prozesskammer erzielt. Damit wird die effiziente, reproduzierbare und partikel-freie Abscheidung von Metalloxiden, Metallnitriden oder Metallen bei hohem Durchsatz gewährleistet. Wegen der vollständigen Gasphasensättigung ist auch die Abscheidung auf mehreren Substraten gleichzeitig möglich. Diese Substrate können gestapelt übereinander oder nebeneinander liegen. Die Substrate können dabei horizontal orientiert oder vertikal orientiert sein. Lokale Verarmungen und damit einhergehendes inhomogenes Schichtwachstum wird vermieden. Während sich nach einem Injektionspuls die Komponente einer Schicht auf der Substratoberfläche formiert, kann der Ausgangsstoff der anderen Komponente zugeführt werden. Beispielsweise können weitere Metalloxide beigemischt werden. Auch dies erfolgt über eine Flüssigkeitsinjektion. Die Injektionsrate bzw. das Puls-Pausenverhältnis kann dabei weitestgehend freigewählt werden. Zur Beeinflussung des Massenflusses kann auch der Vordruck in der Zuleitung zur Injektordüse oder der Massenfluss pro Zeiteinheit variiert werden. Es wird als vorteilhaft angesehen, dass mit dem Verfahren einfache oder gemischt oder dotierte Metalloxide oder Metallnitride abgeschieden werden können. Durch Variation des Injektionsvordrucks bzw. der Induktionsfrequenz oder des Puls/Pausenverhältnis können Schichten unterschiedlicher Qualität unmittelbar aufeinander abgeschieden werden, ohne dass zwischen der Abscheidung der aufeinanderfolgenden Schichten längere Pausen erforderlich sind. Mit dem erfindungsgemäßen Verfahren können auch Gradientenstrukturen abgeschieden werden. Dies erfolgt durch eine kontinuierliche Variation der Massen plus Parameter während des Abscheidens einer Schicht. Hierdurch wird in der Vertikalen eine kontinuierlich sich ändernde Schichtzusammensetzung ausgebildet. Mit dieser Methode können somit auch kontinuierliche Übergänge zwischen zwei abgeschiedenen Schichten erzielt werden. Dies kann sowohl auf Planaren als auch auf hochstrukturierten, insbesondere dreidimensionale Strukturen wie Gräben aufweisenden Oberflächen erfolgen. Die Massenflüsse der Ausgangsstoffe in den Zuleitungen zu den Injektordüsen werden mittels Massenflussmessung ermittelt. Als metallische Komponenten kommen insbesondere folgende Metalle in Betracht: Al, Si, Pr, Ge, Ti, Zr, Hf, Y, La, Ce, Nb, Ta, Mo, Bi, Nd, Ba, Gd, Sr. Mit dem Verfahren können nicht nur aus mehreren Komponenten bestehende Schichten abgeschieden werden. Es ist auch möglich, Schichten, die aus einer Komponente bestehen, abzuscheiden. Beispielsweise ist es möglich, metallische Elektroden abzuscheiden, die aus Pt oder Ro bestehen. Die metallische Komponente wird als metallorganischer Ausgangsstoff eingebracht. Der chemisch reaktive Ausgangsstoff kann in diesem Falle Sauerstoff oder Wasser sein. Mit ihm wird der organische Teil der metallorganischen Verbindung abgeführt. Die Vorrichtung, mit der das beanspruchte Verfahren ausgeübt wird, entspricht derjenigen, die die DE 103 42 890 beschreibt.

Ausführungsbeispiele der Erfindung werden nachfolgend anhand beigefügter Zeichnungen erläutert. Es zeigen:
- Fig. 1: in schematischer Darstellung den Aufbau einer erfindungsgemäßen Vorrichtung,
- Fig. 2: den Verlauf der Gasströme von Precursor (3a), reaktivem Gas (3b) und Trägergas (3c), auszugsweise in Abhängigkeit von der Prozesszeit und
- Fig. 3: eine Darstellung gemäß Figur 2 eines zweiten Ausführungsbeispiels.

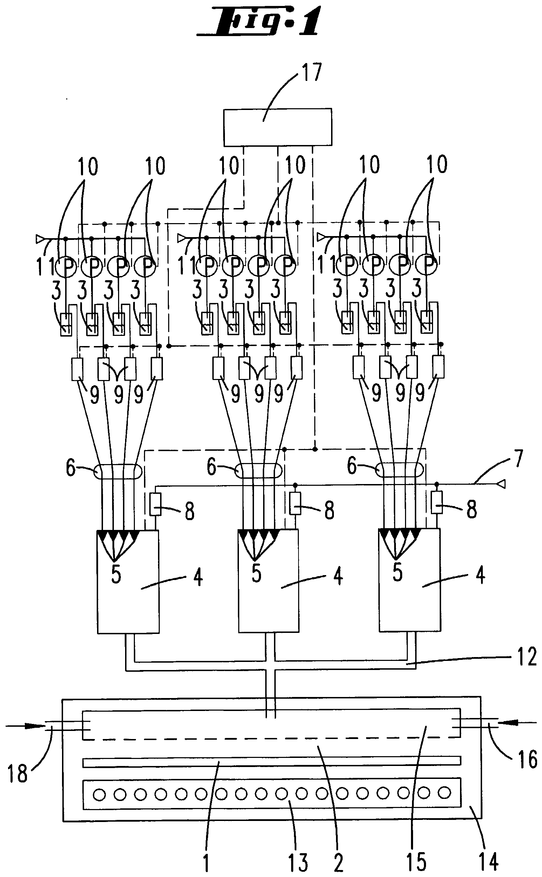

Die Figur 1 zeigt grob schematisch die wesentlichen Elemente einer Vorrichtung zur nicht kontinuierlichen Injektion von flüssigen oder gelösten Metallausgangssubstanzen über eine Mehrkanalinjektionseinheit 6. Die Mehrkanalinjektionseinheit verfügt im Ausführungsbeispiel über mehrere Kanäle 5. Es ist jedoch auch vorgesehen, dass nur jeweils ein einzelner Kanal 5 in eine Verdampfungskammer mündet. Das Ausführungsbeispiel zeigt insgesamt vier Verdampfungskammern 4 mit jeweils einer Injektionseinheit 6. Diese Vorrichtung soll speziell für die Abscheidung von ein- oder mehrkomponentigen Oxyden (Hafniumoxid, Aluminiumoxid, Strontium oder Praseodymoxid etc.) laminierten und gemischt oxidischen Materialien und ein- oder mehrkomponentigen elektrisch leitenden Materialien wie Metall, Metalloxide und elektrisch leitender Halbleiterverbindung dienen. Dann erlaubt das oben und nachfolgend im Detail beschriebene Verfahren die Herstellung komplexer Strukturen aus Passivierungsschichten, dielektrischen und elektrisch leitenden Elektrodenmaterialien auf hochstrukturierten Substraten durch Insitumassenflussregelung der Einzelquellen bei atomarer Schichtdickenkontrolle zu formieren ohne die Prozessierungsfrequenz zu unterbrechen.

Die Figur 1 zeigt einen Reaktor, der eine Reaktorkammer 14 besitzt. An der Reaktorkammer 14 ist nicht dargestellte Peripherie angeschlossen, beispielsweise eine Vakuumpumpe, um die Reaktorkammer 14 und die der Reaktorkammer in Stromrichtung vorgeschalteten Aggregate zu evakuieren. Innerhalb der Reaktorkammer befindet sich eine Heizung 13. Oberhalb der Heizung 13 befindet sich das Substrat, welches mit der Bezugsziffer 1 angedeutet ist. Das Substrat 1 lagert auf einem in der Zeichnung nicht dargestellten Substrathalter. Dieser kann drehangetrieben werden. Oberhalb des Substrates befindet sich die Prozesskammer 2, in welche die Ausgangsstoffe eingebracht werden. Hierzu dient ein oberhalb der Prozesskammer 2 angeordneter, duschkopfartig ausgebildetes Gaseinleitungsorgan 15. Das Gaseinlassorgan 15 begrenzt die Prozesskammer 2 nach oben. Das Substrat bzw. der nicht dargestellte Substrathalter begrenzt die Prozesskammer 2 nach unten. Die von oben in die Prozesskammer 2 einströmenden reaktiven Gase bzw. in Gasen gelöste Flüssigkeiten und Trägergase fließen über die Peripherie aus der Prozesskammer 2 hinaus. Sie werden aus der Reaktorkammer 14 gepumpt.

Eine Zuleitung 12 mündet in die das Gaseinleitungsorgan. Durch die Zuleitung 12 können verdampfte Ausgangsstoffe 3 zusammen mit einem Trägergas 7 in das Gaseinleitungsorgan 15 eingeleitet werden.

Die Rohrleitungen 12 können temperiert sein, um Kondensation zu verhindern. Die Zuleitungen 12 entspringen den oben genannten Verdampfungskammern 4. Jede der Verdampfungskammer 4 weist mindestens eine Injektordüse 5 auf. Mittels der Injektordüse werden Flüssigkeiten in das temperierte Gas, welches sich innerhalb der Verdampfungskammer 4 befindet, eingesprüht. Das dabei entstehende Aerosol oder der dabei entstehende Nebel nimmt von dem in der Verdampfungskammer 4 befindlichen Inertgas Wärmeenergie auf, um sich in die Gasform umzuwandeln.

Das Inertgas wird über einen Massenflussregler 8 in die Verdampfungskammer 4 eingeleitet. Bei dem Inertgas 7 kann es sich um Stickstoff, Wasserstoff oder um ein Edelgas handeln.

Jede Injektionsdüse 5 besitzt eine individuelle Zuleitung, durch welche eine individuelle Flüssigkeit oder ein in einer Flüssigkeit gelöster Ausgangsstoff oder eine flüssige chemisch reaktive Flüssigkeit strömt. Die Massenflüsse dieser Flüssigkeiten werden mit Massenflussmessern 9 gemessen. Den Massenflussmessern 9 befinden sich vorgeordnet die Flüssigkeitsquellen, in welchen sich die Flüssigkeiten 3 befinden. Vor den Flüssigkeitsvorratsbehältern befinden sich Druckcontroller 10. Die Druckcontroller 10 werden mit einem Inertgas 11 beaufschlagt. Mittels der Injektordüsen 5 werden die flüssigen Komponenten in die Verdampfungskammer pulsweise eingesprüht. Die Pulsweiten können zwischen einigen Sekunden und wenigen Millisekunden variiert werden. Im gleichen Spektrum können auch die Pulspausen variiert werden. Demzufolge sind Pulsfrequenzen zwischen 0,1 und 100 Hz möglich.

Die Vorrichtung dient der Beschichtung eines hochstrukturierten Substrates. In der Prozesskammer können auch mehrere Substrate angeordnet sein. Sie hat dann eine andere Gestalt als in der Figur 1 dargestellt. Insbesondere können mehrere Substrate parallel zueinander paketweise angeordnet sein. Die Substrate können sich in der Horizontalen oder Vertikalen erstrecken.

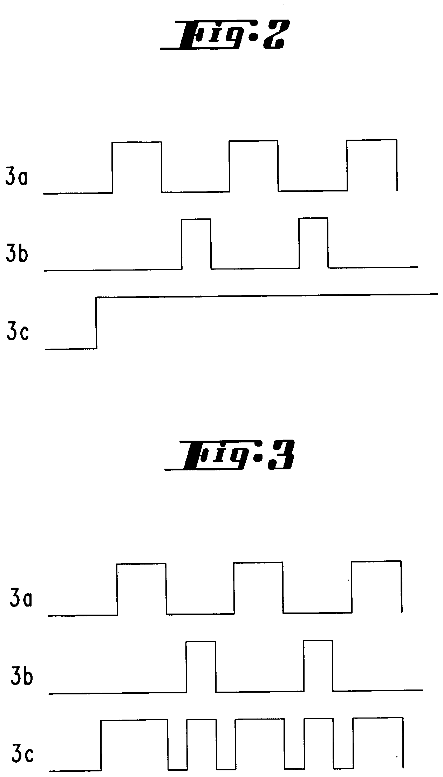

In der Figur 2 wird der typische Verlauf der Pulse, mit welchen die Precursoren 3a, also die metallischen Komponenten und die reaktiven Ausgangsstoffe 3b, also ein chemisch reaktives Gas oder eine chemisch reaktive Flüssigkeit in die jeweilige Verdampfungskammer 4 eingebracht werden. In der Figur 2 ist darüber hinaus der zeitliche Strömungsverlauf des Trägergases 3c dargestellt, bei dem es sich um ein Inertgas handelt.

Erkennbar ist, dass vor dem ersten Puls, mit dem der metallische Ausgangsstoff 3a in die Verdampfungskammer 4 gebracht wird, das inerte Trägergas 3c in die Verdampfungskammer 4 eingebracht wird. Nach Beendigung des Pulses, mit dem der metallische Ausgangsstoff 3a in die Verdampfungskammer 4 eingebracht wird, erfolgt zunächst eine Pause. Der Trägergasstrom 3c kann dabei so groß sein, dass während der Pause und insbesondere und während des Pulses innerhalb der Verdampfungskammer 4 ein vollständiger Gaswechsel stattfindet.

Nach der Pulspause erfolgt das Einsprühen der chemisch reaktiven Flüssigkeit 3b. Anstelle einer chemisch reaktiven Flüssigkeit 3b kann aber auch ein chemisch reaktives Gas eingeleitet werden. Im Ausführungsbeispiel ist die Pulslänge, innerhalb der die chemisch reaktive Substanz in die Verdampfungskammer eingeleitet wird kürzer als die Pulsweite der metallischen Substanz. Nach Beendigung des Pulses erfolgt wiederum eine Pulspause, in welcher lediglich Trägergas 3c in die Verdampfungskammer 4 strömt. Auch hier erfolgt während des Pulses bzw. der Pulspause ein vollständiger Gaswechsel innerhalb der Verdampfungskammer 4.

Der Precursor 3a bzw. die reaktive Substanz 3b können in ein und dieselbe Verdampfungskammer 4 eingebracht werden. Es ist aber auch vorgesehen, dass die beiden Substanzen 3a, 3b in voneinander verschiedene Verdampfungskammern 4 eingebracht werden.

In einer Weiterbildung der Erfindung ist vorgesehen, dass die im Sekundenbereich liegenden Pulse aus einer Vielzahl von im Subsekundenbereich liegenden Pulse frequenzmoduliert werden. Auch hier ist vorgesehen, dass während des Pulseintrages das Trägergas innerhalb der Verdampfungskammer 4 vollständig gesättigt wird. Der Gaswechsel erfolgt auch bei dieser Variante in Zeiten, die unterhalb einer Sekunde liegen.

Bei dem in Figur 3 dargestellten Ausführungsbeispiel entsprechen die Pulsweiten und Pulsformen, mit denen die Precursor 3a bzw. die reaktiven Substanzen 3b in die Verdampfungskammer eingeleitet werden denjenigen, die die Figur 2 zeigt. Anders als beim Ausführungsbeispiel der Figur 2 wird die Trägergaszufuhr nach Einleiten eines Precursorpulses 3a jedoch abgeschaltet. In der darauffolgenden Pulspause wird die Verdampfungskammer evakuiert. Die Evakuierung kann über die Prozesskammer erfolgen. Mit Beginn des Pulses der reaktiven Substanz 3b erfolgt wieder eine Zugabe des Trägergases 3c. Bevorzugt wird die Verdampfungskammer 4 aber vor dem Einbringen der reaktiven Substanz 3b mit Trägergas geflutet, damit diesem die für die Verdampfung erforderliche Wärme entzogen werden kann. Wird anstelle einer flüssigen reaktiven Substanz 3b eine gasförmige reaktive Substanz 3b verwendet, so kann diese in die evakuierte Verdampfungskammer 4 eingebracht werden. Auch hier ist vorgesehen, dass nach Beendigung der Zugabe der reaktiven Substanz 3b die Verdampfungskammer 4 über die Prozesskammer abgepumpt wird.

In einer weiteren Variante des Verfahrens ist vorgesehen, dass über eine Zuleitung 16 ein reaktives Gas unmittelbar in das Gaseinleitungsorgan 15 eingeleitet wird. Es ist auch vorgesehen, dass in das Gaseinleitungsorgan 15 unmittelbar ein Inertgas 18 eingeleitet wird. Die Einleitung des chemisch reaktiven Gases 16 erfolgt vorzugsweise auch gepulst.

Die chemisch reaktiven Ausgangsstoffe können Sauerstoff oder eine Sauerstoffverbindung wie N₂O, H₂O oder Ozon sein. Als reaktiver Ausgangsstoff kann aber auch Stickstoff verwendet werden. Dieser wird vorzugsweise als N₂O oder NH3 in die Verdampfungskammer gebracht.

Die flüssigen Ausgangsstoffe der metallischen Art können die Metalle Al, Si, Pr, Ge, Ti, Zr, Hf, Y, La, Ce, Nb, Ta, Mo, Bi, Nd, Ba, W oder Gd enthalten.

## Patentansprüche

1. Verfahren zum Abscheiden mindestens einer Schicht auf mindestens einem Substrat in einer Prozesskammer, wobei die Schicht aus mindestens einer Komponente besteht, wobei die zumindest eine erste metallische Komponente unter Verwendung einer nicht kontinuierlichen Injektion eines flüssigen oder eines in einer Flüssigkeit gelösten ersten Ausgangsstoffes in ein temperiertes Trägergas in einer Verdampfungskammer verdampft wird, wobei das beim Einsprühen der Flüssigkeit in die Verdampfungskammer entstehende Aerosol von dem sich in der Verdampfungskammer befindlichen Trägergas die Wärmeenergie aufnimmt, um sich in die Gasform umzuwandeln, wobei mindestens eine zweite Komponente als chemisch reaktiver Ausgangsstoff zugeführt wird, und die Ausgangsstoffe abwechselnd in die Prozesskammer eingebracht werden.

2. Verfahren nach Anspruch 1, **dadurch gekennzeichnet, dass** der zweite Ausgangsstoff ein chemisch reaktives Gas oder eine chemisch reaktive Flüssigkeit ist.

3. Verfahren nach Anspruch 2, **dadurch gekennzeichnet, dass** die chemisch reaktive Flüssigkeit verdampft wird.

4. Verfahren nach einem der vorhergehenden Ansprüche, **dadurch gekennzeichnet, dass** die mindestens zwei Ausgangsstoffe (3) abwechselnd in eine Verdampfungskammer (4) injiziert werden.

5. Verfahren nach einem der vorhergehenden Ansprüche, **gekennzeichnet durch** je einen Ausgangsstoff (5) individuell zugeordnete Verdampfungskammer (4).

6. Verfahren nach einem der vorhergehenden Ansprüche, **dadurch gekennzeichnet, dass** die Prozesskammer (2) und gegebenenfalls auch die Verdampfungskammer (4) nach jeder Injektion mit einem Inertgas (7) gespült oder abgepumpt wird.

7. Verfahren nach einem der vorhergehenden Ansprüche, **dadurch gekennzeichnet, dass** das Trägergas (7) in der Verdampfungskammer (4) zufolge der Injektion des Ausgangsstoffes mit dem Ausgangsstoff gesättigt wird.

8. Verfahren nach einem der vorhergehenden Ansprüche, **dadurch gekennzeichnet, dass** die bei jedem Injektionspuls in die Verdampfungskammer (4) gebrachte Gasmasse über den Gasvordruck, die Pulslänge, die Pulspause oder den Massenfluss bestimmt wird.

9. Verfahren nach einem der vorhergehenden Ansprüche, **dadurch gekennzeichnet, dass** mindestens ein inertes Trägergas (16) unmittelbar in die Prozesskammer (2) eingebracht wird.

10. Verfahren nach einem der vorhergehenden Ansprüche, **dadurch gekennzeichnet, dass** der gasförmig vorliegende chemisch reaktive Ausgangsstoff direkt als Gas (18) in die Prozesskammer eingebracht wird.

11. Verfahren nach einem der vorhergehenden Ansprüche, **dadurch gekennzeichnet, dass** der chemisch reaktive Ausgangsstoff eine Sauerstoffverbindung oder eine Stickstoffverbindung ist.

12. Verfahren nach einem der vorhergehenden Ansprüche, **dadurch gekennzeichnet, dass** der chemisch reaktive Ausgangsstoff O₂, O₃, N₂O, H₂O oder NH₃ ist.

13. Verfahren nach einem der vorhergehenden Ansprüche, **dadurch gekennzeichnet, dass** Prozesskammer aktiv beheizt ist und dass der Druck in der Prozesskammer unterhalb oder = 100mbar, 50mbar, 20mbar oder 10mbar ist.

14. Verfahren nach einem der vorhergehenden Ansprüche, **dadurch gekennzeichnet, dass** die flüssigen Ausgangsstoffe oder die in einer Flüssigkeit gelösten Feststoffe oder Flüssigkeiten ein oder mehrere der folgenden Metalle enthalten Al, Si, Pr, Ge, Ti, Zr, Hf, Y, La, Ce, Nb, Ta, Mo, Bi, Nd, Ba, W oder Gd.

15. Verfahren nach einem der vorhergehenden Ansprüche, **dadurch gekennzeichnet, dass** die Schichten konformal auf hochstrukturierte Strukturen, insbesondere dreidimensional strukturierten Strukturen abgeschieden werden.

16. Verfahren nach einem der vorhergehenden Ansprüche, **dadurch gekennzeichnet, dass** die abgeschiedenen Schichten isolierend, passivierend oder elektrisch leitend sind.

17. Verfahren nach einem der vorhergehenden Ansprüche, **dadurch gekennzeichnet, dass** die Schichten aus Metalloxyden, Metallnitriden oder Metallen bestehen.

18. Verfahren nach einem der vorhergehenden Ansprüche, **dadurch gekennzeichnet, dass** die mit Ventilen verschließbaren Injektordüsen so eingestellt sind, dass Nanolaminate, Hyperstrukturen, Nukleationslagen, Mischoxide sowie Gradienten-Schichten hergestellt werden.

19. Verfahren nach einem der vorhergehenden Ansprüche, **dadurch gekennzeichnet, dass** mehrere planare und/oder hochstrukturierte Substrate nebeneinander auf mindestens einem Substrathalter, insbesondere einem drehangetriebenen Substrathalter angeordnet sind.

20. Verfahren nach einem der vorhergehenden Ansprüche, **dadurch gekennzeichnet dass** mehrere planare und/oder hochstrukturierte Substrate vertikal orientiert übereinander und/oder horizontal orientierten nebeneinander und/oder unter Winkeln zwischen vertikal und horizontal orientiert in der Prozesskammer angeordnet sind.

## Claims

1. A method for depositing at least one layer on at least one substrate in a process chamber, wherein the layer consists of at least one component, wherein the at least one first metallic component is vaporized into a temperature-controlled carrier gas, in a vaporization chamber, by means of a discontinuous injection of a first starting material in the form of a liquid or a first starting material dissolved in a liquid, wherein the aerosol formed during spraying of the liquid into the vaporization chamber absorbs thermal energy from the carrier gas located in the vaporization chamber in order to be converted into the gaseous form, wherein at least a second component is supplied as a chemically reactive starting material, and the starting materials are introduced alternately into the process chamber.

2. The method according to claim 1, **characterized in that** the second starting material is a chemically reactive gas or a chemically reactive liquid.

3. The method according to claim 2 **characterized in that** the chemically reactive liquid is vaporized.

4. The method according to one of the preceding claims, **characterized in that** the at least two starting materials (3) are injected alternately into a vaporization chamber (4) .

5. The method according to one of the preceding claims, **characterized by** each starting material (5) being individually associated with a vaporization chamber (4) .

6. The method according to one of the preceding claims, **characterized in that** the process chamber (2) and optionally also the vaporization chamber (4) is purged with an inert gas (7) or evacuated after each injection.

7. The method according to one of the preceding claims, **characterized in that** the carrier gas (7) in the vaporization chamber (4) is saturated with the starting material as a result of the injection of the starting material.

8. The method according to one of the preceding claims, **characterized in that** the mass of gas that is brought into the vaporization chamber (4) with each injection pulse is determined by means of the gas admission pressure, the pulse length, the pulse pause or the mass flow.

9. The method according to one of the preceding claims, **characterized in that** at least one inert carrier gas (16) is introduced directly into the process chamber (2).

10. The method according to one of the preceding claims, **characterized in that** the chemically reactive starting material in gaseous form is introduced into the process chamber directly as a gas (18).

11. The method according to one of the preceding claims, **characterized in that** the chemically reactive starting material is an oxygen compound or a nitrogen compound.

12. The method according to one of the preceding claims, **characterized in that** the chemically reactive starting material is O₂, O₃, N₂O, H₂O or NH₃.

13. The method according to one of the preceding claims, **characterized in that** the process chamber is actively heated and **in that** the pressure in the process chamber is below or equal to 100 mbar, 50 mbar, 20 mbar or 10 mbar.

14. The method according to one of the preceding claims, **characterized in that** the liquid starting materials or the solid materials or liquids dissolved in a liquid contain one or more of the following metals: Al, Si, Pr, Ge, Ti, Zr, Hf, Y, La, Ce, Nb, Ta, Mo, Bi, Nd, Ba, W or Gd.

15. The method according to one of the preceding claims, **characterized in that** the layers are deposited conformally on highly structured structures, particularly three-dimensionally structured structures.

16. The method according to one of the preceding claims, **characterized in that** the deposited layers are insulating, passivating or electrically conducting.

17. The method according to one of the preceding claims, **characterized in that** the layers consist of metal oxides, metal nitrides or metals.

18. The method according to one of the preceding claims, **characterized in that** the injector nozzles, which can be closed by valves are set in such a way that nanolaminates, hyperstructures, nucleation layers, mixed oxides and gradient layers are produced.

19. The method according to one of the preceding claims, **characterized in that** a number of planar and/or highly structured substrates are disposed side by side on at least one substrate holder, in particular a rotationally driven substrate holder.

20. The method according to one of the preceding claims, **characterized in that** a number of planar and/or highly structured substrates are disposed in the process chamber vertically oriented one above the other and/or horizontally oriented side by side and/or oriented at angles between vertical and horizontal.

## Revendications

1. Procédé pour déposer au moins une couche sur au moins un substrat dans une chambre de traitement, ladite couche étant constituée d'au moins un composant, dans lequel ledit au moins un premier composant métallique est évaporé dans une chambre d'évaporation en utilisant une injection non continue d'une première matière de départ liquide ou dissoute dans un liquide dans un gaz porteur chauffé, dans lequel l'aérosol formé lors de la pulvérisation du liquide dans la chambre d'évaporation absorbe l'énergie thermique du gaz porteur présent dans la chambre d'évaporation pour se transformer dans la forme gazeuse, dans lequel au moins un deuxième composant est amené comme matière de départ chimiquement réactive, et les matières de départ sont introduites alternativement dans la chambre de traitement.

2. Procédé selon la revendication 1, **caractérisé en ce que** la deuxième matière de départ est un gaz chimiquement réactif ou un liquide chimiquement réactif.

3. Procédé selon la revendication 2, **caractérisé en ce que** le liquide chimiquement réactif est vaporisé.

4. Procédé selon l'une des revendications précédentes, **caractérisé en ce que** les au moins deux matières de départ (3) sont alternativement injectées dans une chambre d'évaporation (4).

5. Procédé selon l'une des revendications précédentes, **caractérisé par** une chambre d'évaporation (4) associée individuellement à chaque matière de départ (5).

6. Procédé selon l'une des revendications précédentes, **caractérisé en ce que** la chambre de traitement (2) et éventuellement aussi la chambre d'évaporation (4) sont purgées avec un gaz inerte (7) ou pompées après chaque injection.

7. Procédé selon l'une des revendications précédentes, **caractérisé en ce que** le gaz porteur (7) dans la chambre d'évaporation (4) est saturé avec la matière de départ après l'injection de la matière de départ.

8. Procédé selon l'une des revendications précédentes, **caractérisé en ce que** la masse de gaz introduite dans la chambre d'évaporation (4) pendant chaque impulsion d'injection est déterminée par la pression d'admission du gaz, la durée d'impulsion, la pause d'impulsion ou le débit massique.

9. Procédé selon l'une des revendications précédentes, **caractérisé en ce qu'**au moins un gaz porteur inerte (16) est introduit directement dans la chambre de traitement (2).

10. Procédé selon l'une des revendications précédentes, **caractérisé en ce que** la matière de départ chimiquement réactive présente sous forme gazeuse est introduite directement sous la forme de gaz (18) dans la chambre de traitement.

11. Procédé selon l'une des revendications précédentes, **caractérisé en ce que** la matière de départ chimiquement réactive est un composé d'oxygène ou un composé d'azote.

12. Procédé selon l'une des revendications précédentes, **caractérisé en ce que** la matière de départ chimiquement réactive est O₂, O₃, N₂O, H₂O ou NH₃.

13. Procédé selon l'une des revendications précédentes, **caractérisé en ce que** la chambre de traitement est chauffée activement et que la pression dans la chambre de traitement est inférieure ou égal à 100mbar, 50mbar, 20mbar ou 10mbar.

14. Procédé selon l'une des revendications précédentes, **caractérisé en ce que** les matières de départ liquides ou les solides dissous dans un liquide ou les liquides comprennent un ou plusieurs des métaux suivants : Al, Si, Pr, Ge, Ti, Zr, Hf, Y, La, Ce, Nb, Ta, Mo, Bi, Nd, Ba, W ou Gd.

15. Procédé selon l'une des revendications précédentes, **caractérisé en ce que** les couches sont déposées de manière conforme sur des structures hautement structurées, en particulier des structures structurées en trois dimensions.

16. Procédé selon l'une des revendications précédentes, **caractérisé en ce que** les couches déposées sont isolantes, passivantes ou électriquement conductrices.

17. Procédé selon l'une des revendications précédentes, **caractérisé en ce que** les couches comprennent des oxydes métalliques, des nitrures métalliques ou des métaux.

18. Procédé selon l'une des revendications précédentes, **caractérisé en ce que** les buses d'injection obturables au moyen de valves sont réglées de manière à produire des nano-stratifiés des hyper-structures, des couches de nucléation, des oxydes mixtes, ainsi que des couches de gradient.

19. Procédé selon l'une quelconque des revendications précédentes, **caractérisé en ce qu'**une pluralité de substrats plans et/ou très structurés sont agencés côte à côte sur au moins un porte-substrat, en particulier un porte-substrat entraîné en rotation.

20. Procédé selon l'une des revendications précédentes, **caractérisé en ce qu'**une pluralité de substrats plans et/ou très structurés sont agencés dans la chambre de traitement les uns au-dessus des autres en étant orientés verticalement et/ou les uns à côté des autres en étant orientés horizontalement et/ou selon des angles entre la verticale et l'horizontale.
